# FASCICULE DE BREVET EUROPEEN

(11) **EP 0 331 963 B1**
(45) Date de publication et mention de la délivrance du brevet: **03.11.1993**
(21) Numéro de dépôt: 89102938.1
(22) Date de dépôt: 20.02.1989
(51) Int. Cl.: H03H 17/06

(54) **Filtre numérique à décimation intégrée**
Digitales Filter mit integrierter Dezimierung
Integrated decimating digital filter

(30) Priorité: 24.02.1988 FR 8802235
(43) Date de publication de la demande: 13.09.1989
(73) Titulaire: ALCATEL TELSPACE, 92734 Nanterre Cédex (FR); ALCATEL N.V., NL-1077 XX Amsterdam (NL)
(72) Inventeur: Morel, Patrick, F-95610 Eragny sur Oise (FR)
(74) Mandataire: Weinmiller, Jürgen

(56) Documents cités:
- AEÜ, vol. 36, no. 9, 1982, pages 349-355, Stuttgart, DE; H.W. SCHÜSSLER et al.: "On partly digital anti-aliasing filters"
- ICASSP '85 - PROCEEDINGS OF THE IEEE INTERNATIONAL CONFERENCE ON ACOUSTICS SPEECH, AND SIGNAL PROCESSING, Tampa, Florida, 26-29 mars 1985, vol. 1 des 4, pages 65-68, IEEE, New York, US; T. SARAMÄKI et al.: "Design of linear-phase partly digital anti-aliasing filters"
- IEEE TRANSACTIONS ON ACOUSTICS, SPEECH, AND SIGNAL PROCESSING, vol. ASSP-23, no. 4, août 1975, pages 353-357, New York, US; R.R. SHIVELY: "On multistage finite impulse response (FIR) filters with decimation"
- IEEE TRANSACTIONS ON ACOUSTICS, SPEECH, AND SIGNAL PROCESSING, vol. ASSP-32, no. 5, octobre 1984, pages 1023-1036, IEEE, New York, US; T. SARAMÄKI: "A class of linear-phase FIR filters for decimation, interpolation, and narrow-band filtering"

## Description

La présente invention concerne les filtres numériques et, plus particulièrement, les filtres numériques traitant un signal suréchantillonné pour la mise en forme de ce signal et effectuant une décimation fournissant un signal ayant une fréquence d'échantillonnage réduite.

L'invention est applicable, notamment, dans la transmission de données par voie radio-électrique, sous une forme que l'on peut considérer comme analogique, lorsque, à la réception, le traitement du signal transmis, ramené en bande de base, doit être effectué de façon numérique. La conversion sous forme numérique du signal analogique transmis s'effectue alors, par échantillonnage et codage, à une fréquence beaucoup plus élevée que celle qui est préconisée par Shannon, en fonction de la largeur de bande du signal à coder. Un tel suréchantillonnage permet une réalisation plus simple et plus économique des filtres passe-bas analogiques qui doivent précéder de toute façon la conversion analogique - numérique . Le filtrage de Nyquist du canal de transmission peut en outre être effectué sur le signal suréchantillonné, avant la décimation.

La décimation est une opération qui consiste, dans une suite d'échantillons à fréquence élevée d'un signal d'entrée numérique, à ne conserver qu'un échantillon sur R échantillons. R est le rapport de décimation. L'analyse montre que si R est trop élevé par rapport au spectre du signal d'entrée, la décimation produit un repliement du spectre qu'il convient d'éviter. Pour ce faire, il est courant de procéder à une mise en forme du signal d'entrée, avant la décimation. Il s'agit d'un filtrage de type passe-bas qui n'affecte pas le signal devant être conservé après la décimation.

Le moyen usuel pour accomplir un tel filtrage sur le signal numérique est un filtre à réponse impulsionnelle finie (RIF), dans lequel chaque échantillon de sortie est la somme de N échantillons antérieurs du signal d'entrée affectés de coefficients appropriés. Ce filtre effectue N multiplications en parallèle dont les résultats sont retardés et additionnés. Les opérations de multiplication sont les plus complexes et le temps qu'elles demandent limite le débit maximal du filtre. Un filtre réalisé dans une technologie donnée a ainsi un domaine d'application limité.

Toutefois, il est également connu qu'un filtre RIF peut être remplacé par la combinaison en série d'un préfiltre et d'un égaliseur. Ceci est exposé dans l'article "A new approach to FIR digital filters with fewer multipliers et reduced sensitivity" de J.W. Adams et A.N. Willson, publié dans IEEE Transactions on Circuits and Systems, vol. CAS-30, pages 277-283, de mai 1983. Le préfiltre est un filtre RIF simplifié comportant un nombre réduit de coefficients très simples (0, -1, 1...) tels qu'il ne demandent pas d'effectuer de multiplications.

Le débit maximal possible d'un tel filtre n'est limité que par les opérations d'addition. Il est considérablement plus élevé que dans le cas d'un filtre RIF classique. L'égaliseur est également un filtre RIF et il a pour rôle de corriger la fonction de transfert du préfiltre et de faire que la fonction de transfert globale (préfiltre plus égaliseur) soit celle que l'on désire. Comme l'égaliseur apporte seulement une correction, il est d'ordre relativement faible et n'effectue donc qu'un faible nombre de multiplications. Dans le cas d'une réalisation matérielle, en intégration à très grande échelle (VLSI), cela conduit à une économie de la surface occupée par le filtre. La limitation de la fréquence d'échantillonnage maximale acceptable par le filtre est la même que dans les cas du filtre RIF classique.

Comme indiqué au début de ce texte, l'invention s'applique en particulier, mais non exclusivement, aux cas où le signal suréchantillonné doit aussi faire l'objet d'u filtrage pour les besoins de la transmission (filtre de Nyquist). Cette opération de filtrage s'effectue necessairement avant la décimation. Elle peut bien entendu être combinée avec celle que l'on vient de mentionner et qui est propre à la décimation. Cela conduira à des coefficients différents et rendra généralement plus aigus les problèmes de fréquence d'échantillonnage maximale limitée dans les deux modes de filtrage évoqués plus haut.

La présente invention se propose de fournir une solution à ces problèmes, sous la forme d'un filtre à décimation intégrée dont aucune partie n'effectue des multiplications à la fréquence d'échantillonnage élevée du signal d'entrée.

Le filtre à décimation intégrée de la présente invention comprend, en cascade, un préfiltre, sous la forme d'un filtre RIF simplifié en ce qu'il ne comporte pas l'exécution de multiplication á plusieurs bits, un décimateur et un égaliseur, les caractéristiques de cet égaliseur étant adaptées pour tenir compte de l'effet de la décimation sur le signal qui lui est soumis et l'égaliseur seul effectuant des opérations de multiplication à plusieurs bits.

Dans le filtre à décimation intégrée de l'invention, l'égaliseur reçoit un signal à fréquence d'échantillonnage réduite par le décimateur. Il pourra ainsi être d'ordre inférieur à celui qui trairerait un signal à la fréquence d'échantillonnage élevée du signal d'entrée, ce qui apportera une économie par la réduction du nombre de multiplications à effectuer, en même temps que le temps disponible pour effectuer chaque multiplication augmentera grâce à la réduction de la fréquence d'échantillonage, ce qui apportera un gain sur la fréquence d'échantillonnage maximale admissible du signal d'entrée, ou une économie sur les moyens nécessaires pour réaliser les multiplications.

Les différents objets et caractéristiques de l'invention seront maintenant exposés de façon plus detaillée en se reportant aux figures annexées qui représentent :
- la figure 1, la schéma général d'un filtre RIF,
- la figure 2, une structure de filtre comprenant un préfiltre et un égaliseur,
- la figure 3, le diagramme général d'un décimateur classique comprenant un filtre passe-bas d'entrée,
- la figure 4, le diagramme général d'un filtre à décimation intégrée selon la présente invention.

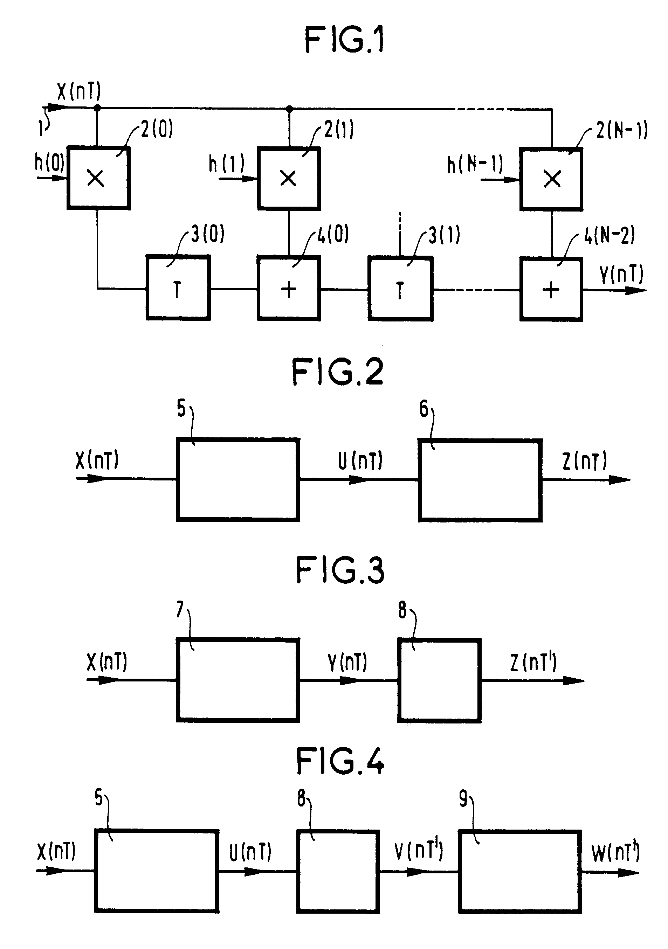

La figure 1 fournit le schéma général d'un filtre RIF. A l'entrée 1 d'un tel filtre est appliqué un signal d'entrée numérique à fréquence d'échantillonnage élevée X(nT). Ce signal est fourni à N multiplicateurs 2(0) à 2(N-1) recevant chacun un coefficient qui lui est propre h(0) à h(N-1). Le produit d'un échantillon du signal X(nT) avec le coefficient h(0), issu du multiplicateur 2(0), est retardé d'une période d'échantillonnage, dans un élément à retard (3(0), avant d'être additionné, dans un additionneur 4(0) avec le produit de l'échantillon suivant du signal X(nT) par le coefficient h(1), issu du multiplicateur 2(1). La somme obtenue est à son tour retardée d'une période d'échantillonnage par un élément à retard 3(1), avant d'être additionnée au produit fourni par le multiplicateur suivant à nouveau, et ainsi de suite, jusqu'à l'additionneur 4(N-2), lequel fournit un signal de sortie numérique filtré Y(nT).

Les coefficients h(0) à h(N-1) sont des nombres codés sur plusieurs bits. Les opérations de multiplication sont donc relativement longues. Comme leur durée ne peut pas dépasser celle d'une période d'échantillonnage, ce sont les moyens employés pour réaliser les multiplications qui définissent alors la fréquence d'échantillonnage maximale admissible pour le signal d'entrée, ou encore, si la fréquence d'échantillonnage est fixée, elle conditionnera les moyens à employer pour réaliser les multiplications. Dans certains cas, une telle contrainte peut mener à des conflits pratiquement insolubles.

La figure 2 représente une structure recevant le signal X(nT) et comprenant en cascade un préfiltre 5 fournissant le signal U(nT) et un égaliseur 6 fournissant le signal Z(nT). Une telle structure peut être équivalente au filtre de la figure 1 et le signal Z(nT) sensiblement identique au signal Y(nT). Elle est discutée dans l'article "A new approach to FIR digital filters with fewer multipliers et reduced sensitivity" de J.W. Adams et A.N. Willson, publié dans IEEE Transactions on Circuits and Systems, vol. CAS-30, pages 277-283, de mai 1983. Elle présente l'avantage que le préfiltre est un filtre RIF dont les coefficients sont tels (0, -1, 1...) que le filtre ne comporte pas de multiplication , ce qui lève, en ce qui le concerne, la contrainte mentionnée plus haut, tandis que l'égaliseur est un filtre RIF à coefficients peu nombreux, de sorte que, si la contrainte en question subsiste, elle ne porte que sur un nombre réduit de multiplicateurs, ce qui l'allège, en terme de coût. On doit toutefois souligner que cette structure reste soumise à la limitation exposée précédemment, du fait de la présence de multiplicateurs, en ce qui concerne la fréquence d'échantillonnage maximale.

La figure 3 représente une structure de décimateur classique traitant un signal d'entrée X(nT) et comprenant en cascade un filtre passe-bas 7, qui peut être le filtre de la figure 2, fournissant le signal Y(nT), et un étage de décimation 8 fournissant un signal Z(nT′) qui n'est autre que le signal Y(nT) dont on n'a conservé qu'un échantillon sur R, rapport entre les périodes T′ et T.

Dans ce décimateur, la fréquence d'échantillonnage maximale admissible est également limitée du fait de la présence de multiplicateurs, que le filtre 7 soit réalisé sous la forme illustrée à la figure 2 ou sous la forme illustrée à la figure 1.

Par ailleurs, si ce décimateur classique doit être aussi utilisé pour le filtrage du signal d'entrée, avant décimation, il suffit de modifier en conséquence les coefficients de filtre, et généralement d'en ajouter, ce qui peut tout au plus rendre plus lourde la contrainte considérée.

La présente invention propose un moyen d'écarter sensiblement cette contrainte. Cette solution est illustrée par la figure 4 qui représente un filtre à décimateur intégré conforme à l'invention. Ce filtre comprend un préfiltre 5 conforme à celui de la figure 2, recevant le signal X(nT) et fournissant le signal U(nT) et, tout comme le décimateur de la figure 3, un étage de décimation 8, lequel fournit un signal V(nT′), dont la période est réduite dans le rapport R. Cet étage décimateur est suivi par un égaliseur 9, remplissant, du point de vue du traitement du signal, le même rôle vis-à-vis du signal V(nT′) que l'égaliseur 6 de la figure 2 vis-à-vis du signal U(nT). Le signal W(nT′) fourni par cet égaliseur, par l'adoption de coefficients appropriés pour le filtre 9, peut être sensiblement identique au signal Z(nT′) de la figure 3. Le calcul de ces coefficients, en tenant compte de la fréquence d'échantillonnage réduite, est bien connu dans la technique. On peut toutefois souligner que, par rapport à la structure de la figure 2, l'égaliseur fonctionne avec une fréquence d'échantillonnage divisée par R, de sorte que les opérations de multiplication disposeront d'une durée multipliée par R, pour un même signal d'entrée, ou que la fréquence d'échantillonnage du signal d'entrée peut être augmentée en conséquence. De plus l'analyse montre que l'égaliseur, dans ce cas, peut être d'un ordre inférieur et comporter, par conséquent, un nombre réduit de multiplicateurs.

La présente invention, en adoptant une structure de filtre avec un préfiltre traitant des signaux à la fréquence d'échantillonnage élevée du signal d'entrée, sans employer de multiplicateur, puis en complètant le traitement dans un égaliseur, après décimation, à une fréquence d'échantillonage réduite, permet donc tout à la fois d'écarter la contrainte portant sur la fréquence d'échantillonnage du signal d'entrée et d'effectuer une économie substantielle sur les circuits de l'égaliseur.

## Revendications

1. Filtre numérique à décimation intégrée traitant un signal suréchantillonné pour la mise en forme de ce signal et effectuant une décimation fournissant un signal ayant une fréquence d'échantillonnage réduite comprenant, en cascade, un préfiltre (5), sous la forme d'un filtre RIF simplifié en ce qu'il ne comporte pas l'exécution de multiplication à plusieurs bits, un étage décimateur (8) et un égaliseur (9), les caractéristiques de cet égaliseur étant adaptées pour tenir compte de l'effet de la décimation sur le signal qui lui est soumis et l'égaliseur seul effectuant des opérations de multiplication á plusieurs bits.

## Claims

1. A digital filter with integrated decimation and processing an oversampled signal for the purpose of shaping said signal, and performing decimation to provide a signal at a lower sampling rate, the filter comprising, in cascade, a prefilter (5), constituted by a FIR filter which is simplified by the fact that it does not perform multiplications on several bits, a decimator stage (8), and an equalizer (9), with the characteristics of said equalizer being adapted to take account of the effect of decimation on the signal which is subjected thereto, and with multiplication on several bits being performed by the equalizer, only.

## Patentansprüche

1. Digitales Filter mit integrierter Dezimierung, das ein übergetastetes Signal verarbeitet, um es in Form zu bringen und eine Dezimierung durchzuführen, die ein Signal mit einer verringerten Tastfrequenz liefert, wobei das Filter in Kaskade ein Vorfilter (5) in Form eines so vereinfachten FIR-Filters, daß es keine Multiplikationen über mehrere Bits erfordert, eine Dezimierstufe (8) und einen Entzerrer (9) aufweist, dessen Kennwerte unter Berücksichtigung des Dezimierungseffekts auf das an ihn angelegte Signal angepaßt sind, und daß der Entzerrer alleine Multiplikationsoperationen über mehrere Bits durchführt.
